# EUROPEAN PATENT APPLICATION

(11) **EP 4 589 723 A1**
(43) Date of publication of application: **23.07.2025**
(21) Application number: 24806982.5
(22) Date of filing: 22.04.2024
(51) Int. Cl.: H01M 10/48, G01R 31/389, G01R 31/392, H01M 10/44, H02H 5/04, H02J 7/00

(54) **BATTERY PACK**

(30) Priority: 18.05.2023 JP 2023082305; 18.05.2023 JP 2023082304
(71) Applicant: Kubota Corporation, Osaka 556-8601 (JP)
(72) Inventor: FUJII, Yasuo, Sakai-shi, Osaka 592-8331 (JP); KOYAMA, Kazuaki, Sakai-shi, Osaka 592-8331 (JP); HORITA, Tatsuhiko, Sakai-shi, Osaka 592-8331 (JP); NAGAMORI, Yuko, Sakai-shi, Osaka 592-8331 (JP); KIMURA, Ryota, Sakai-shi, Osaka 592-8331 (JP)
(74) Representative: Dolleymores
(86) International application number: PCT/JP2024/015779
(87) International publication number: WO 2024/237028

(57) **Abstract**

[Problem] Provided is a battery pack capable of conveniently diagnosing, by itself, the degree of degradation of the internal resistance of a battery. [Solution] A battery pack 40 includes: a battery 50; contactors 75, 76; an AC constant current source 3 supplying an AC constant current with a predetermined frequency to the battery 50; an AC voltmeter 4 detecting the value of a voltage between a positive electrode 51 and a negative electrode 52 when the AC constant current is supplied to the battery 50; and a control unit 85 supplying an AC constant current to the battery 50 by controlling the AC constant current source **3,** calculating the internal resistance of the battery 50 on the basis of the value of the voltage detected by the AC voltmeter 4, and diagnosing the degree of degradation of the battery 50 on the basis of the internal resistance.

## Description

### Technical Field

The present invention relates to a battery pack mounted on a hybrid system.

### Background Art

A hybrid system that concurrently uses an engine, a motor, and a battery has been developed for industrial machines, automobiles and the like in response to a request for lower pollution and conservation of fossil fuel resources. The hybrid system includes, for example, an internal combustion engine for generating power by using fossil fuels, a motor for assisting the internal combustion engine, and a battery such as a lithium-ion battery or the like, for example, for supplying electric power to the motor.

In the hybrid system, a battery pack including the lithium-ion battery, for example, is used as a power source for driving the motor. In the lithium-ion battery, the internal resistance increases due to storage for a long time or usage for a long time, leading to an increased amount of voltage drop during discharging, resulting in the occurrence of degradation of the internal resistance. If degradation of the internal resistance occurs, an ECU (Electronic Control Unit) may impose output limitations in order to suppress the voltage range.

PTL 1 discloses a degradation detection method and a degradation detector for a lithium secondary battery, which are for: detecting at least one of: a group of a closed-circuit charge cutoff voltage and a post-charging open-circuit voltage of a lithium secondary battery, and a group of a closed-circuit discharge cutoff voltage and a post-discharging open-circuit voltage of the lithium secondary battery; calculating a determination value from the detected group of voltages; and estimating the degree of degradation of the lithium secondary battery on the basis of a result of comparing the determination value with a reference value stored in advance. However, in the degradation detection method and the degradation detector described in PTL 1, it is necessary to detect at least one of: a group of a closed-circuit charge cutoff voltage and a post-charging open-circuit voltage of a rechargeable lithium battery, and a group of a closed-circuit discharge cutoff voltage and a post-discharging open-circuit voltage of the rechargeable lithium battery, which requires a discharge resistor or the like capable of charging or discharging. Therefore, it is difficult to conveniently diagnose the degree of degradation of the internal resistance of a battery by means of a battery pack alone, without providing a discharge resistor such as a DC/DC converter.

PTL 2 discloses a degradation determination method for a storage battery, the method including: measuring the internal impedance of a sample storage battery during discharging; and determining the degradation of the sample storage battery on the basis of the maximum value of the internal impedance during the rapid rise thereof immediately before the discharge cutoff voltage being greater than the maximum value of the internal impedance of a non-defective storage battery. However, in the degradation determination method for a storage battery described in PTL 2, as in PTL **1,** a load serving as a discharge resistor is required. Therefore, it is difficult to conveniently diagnose the degree of degradation of the internal resistance of a battery by means of a battery pack alone.

PTL 3 discloses a capacity termination alarm system for a secondary battery, the system including: a secondary battery; a circuit for measuring the internal impedance of the secondary battery by using an AC voltage having a predetermined cycle; and an alarm circuit for issuing an alarm when the measured internal impedance value of the circuit is greater than or equal to a predetermined value. However, the secondary battery described in PTL 3 is not a battery (that is, **an** assembled battery of a lithium-ion battery) of a battery pack mounted on a hybrid system. Since the battery pack mounted on the hybrid system includes various electrical devices such as contactors, there is still room for improvement in applying the degradation diagnosis, which is based on the measurement of the internal impedance of the secondary battery, to the assembled battery of the lithium-ion battery.

From the above, regarding the battery pack mounted on the hybrid system, it is desired that the degree of degradation of the internal resistance of a battery can be conveniently diagnosed by means of the battery pack alone.

### Citation List

### Patent Literature

PTL 1: Japanese Patent Application Publication No. 2008-192607
PTL 2: Japanese Patent Application Publication No. H09-134742
PTL 3: Japanese Patent Application Publication No. S63-157080

### Summary of Invention

### Technical Problem

The present invention has been made in view of the aforementioned circumstances and has an object to provide a battery pack capable of conveniently diagnosing, by itself, the degree of degradation of the internal resistance of a battery. Solution to Problem

A first aspect of the present invention is a battery pack mounted on a hybrid system, the battery pack including: a battery for supplying electric power to a motor generator of the hybrid system; a contactor provided on at least one of a first wiring between a positive electrode of the battery and the motor generator and a second wiring between a negative electrode of the battery and the motor generator, and performing opening/closing of at least one of the first wiring and the second wiring; an AC constant current source supplying to the battery an AC constant current with a predetermined frequency; an AC voltmeter detecting a value of a voltage between the positive electrode and the negative electrode when the AC constant current is supplied to the battery; and a control unit supplying the AC constant current to the battery by controlling the AC constant current source, calculating internal resistance of the battery on the basis of the value of the voltage detected by the AC voltmeter, and diagnosing a degree of degradation of the battery on the basis of the internal resistance.

A second aspect of the present invention is a battery pack mounted on a hybrid system, the battery pack including: a casing; a battery provided inside the casing and supplying electric power to a motor generator of the hybrid system; a contactor provided on at least one of a first wiring between a positive electrode of the battery and the motor generator and a second wiring between a negative electrode of the battery and the motor generator, and performing opening/closing of at least one of the first wiring and the second wiring; a third wiring connected to the first wiring; a fourth wiring connected to the second wiring; a first terminal connected to an end of the third wiring and provided in the casing, and connected to one terminal of a measuring device measuring the internal resistance of the battery; and a second terminal connected to an end of the fourth wiring and provided in the casing, and connected to another terminal of the measuring device.

### Advantageous Effects of Invention

According to the present invention, a battery pack capable of conveniently diagnosing the degree of degradation of the internal resistance of a battery by itself can be provided.

### Brief Description of Drawings

[Fig. 1]

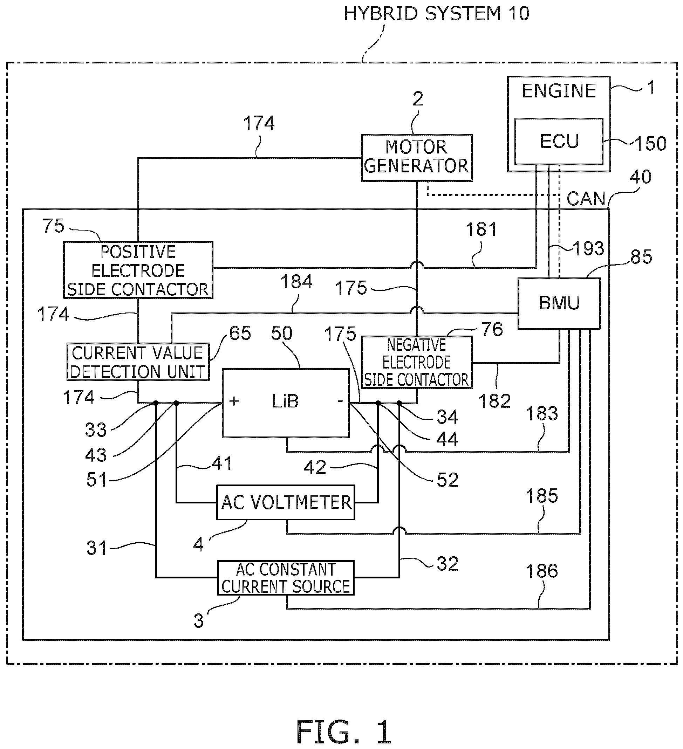

   Fig. 1 is a block diagram showing a hybrid system on which a battery pack according to a first embodiment of the present invention is mounted.
[Fig. 2]

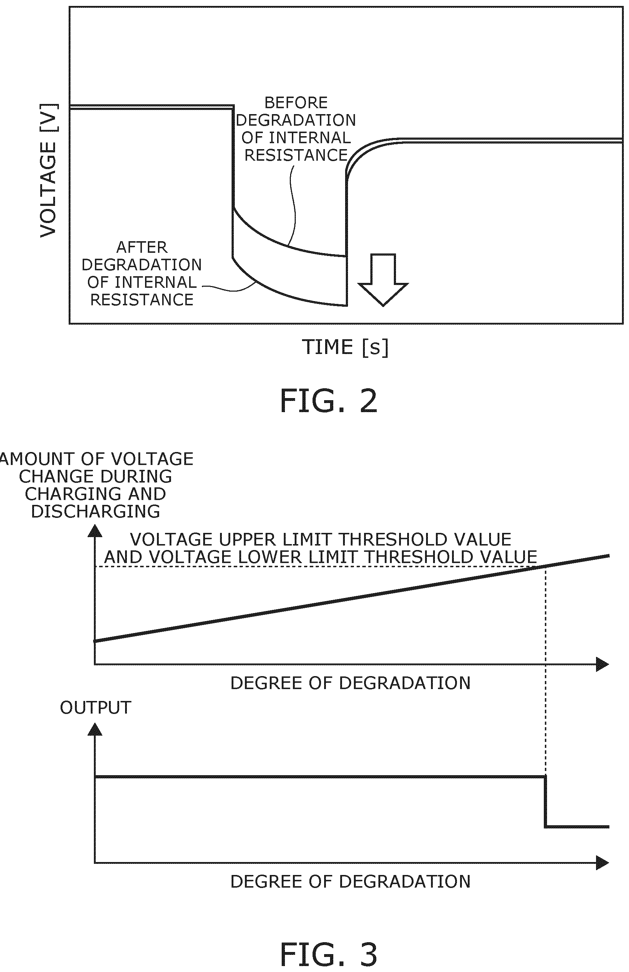

   Fig. 2 is a graph showing a behavior example of the voltage fluctuation of the battery when a current flows from the battery toward the motor generator.
[Fig. 3]
   Fig. 3 is a graph showing the relationship between the degree of degradation and the amount of voltage change during charging and discharging and between the degree of degradation and the output.
[Fig. 4]

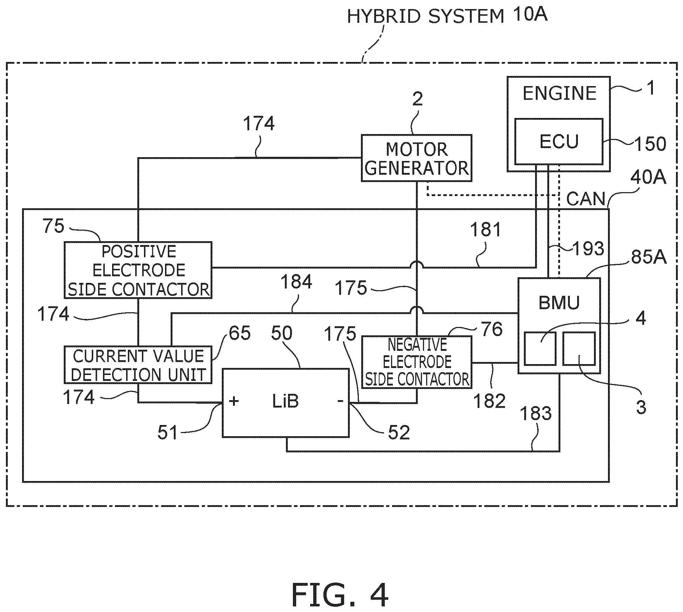

   Fig. 4 is a block diagram showing a hybrid system on which a battery pack according to a second embodiment of the present invention is mounted.
[Fig. 5]

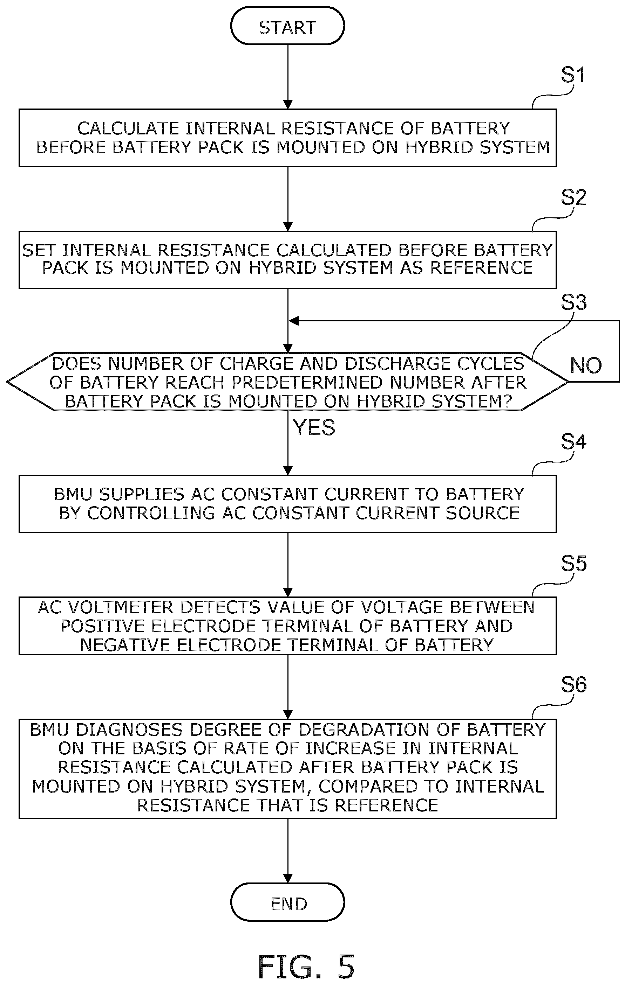

   Fig. 5 is a flowchart showing the diagnosis processing of the degree of degradation of the battery according to this embodiment.
[Fig. 6]

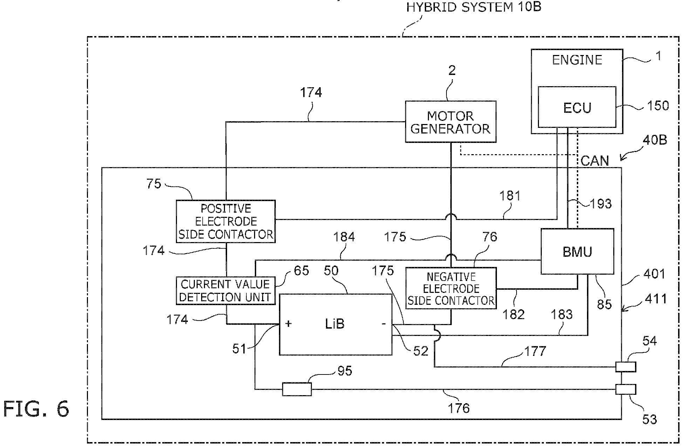

   Fig. 6 is a block diagram showing a hybrid system on which a battery pack according to a third embodiment of the present invention is mounted.

### Description of Embodiments

Hereinafter, an embodiment of the present invention will be explained with reference to the drawings.

Note that the embodiment explained below is a preferred embodiment of the present invention and thus, technically preferable various limitations are given, but a range of the present invention is not limited to these aspects unless there is a description that limits the present invention in particular in the following description. Moreover, in each of the drawings, the same signs are given to the same configuration elements, and detailed description will be omitted as appropriate.

Fig. 1 is a block diagram showing a hybrid system on which a battery pack according to a first embodiment of the present invention is mounted.

The hybrid system 10 shown in Fig. 1 includes an engine 1, a motor generator 2, and a battery pack 40.

The engine 1 is a multi-cylinder diesel engine such as a supercharged-type high-output 3-cylinder engine or 4-cylinder engine having a turbocharger, for example. However, the engine 1 is not limited to the diesel engine. The engine 1 includes an ECU (Electronic Control Unit) 150. The ECU 150 controls an operation of the engine 1 and controls the motor generator 2 by performing communication with the motor generator 2 over a CAN (Controller Area Network), for example.

When power is required such as at the start or at the acceleration of an industrial machine or the like on which the hybrid system 10 is mounted, the motor generator 2 operates using electric power supplied from the battery pack 40 and supports the engine **1.** Note that the hybrid system 10 is mounted on the industrial machine or the like including a construction machine such as a forklift, and an agricultural machine such as a tractor, for example. Moreover, the motor generator 2 generates power by converting kinetic energy of an industrial machine or the like on which the hybrid system 10 is mounted to electric energy by using a regenerative brake or the like. The motor generator 2 has a built-in inverter. However, the inverter does not necessarily have to be built in to the motor generator 2 but may be provided separately from the motor generator **2.**

The battery pack 40 includes a battery 50, and a BMU (Battery Management Unit) 85. The BMU 85 of this embodiment is an example of the "control unit" of the present invention. The battery 50 is provided as a driving power source of the motor generator 2 and supplies electric power to the motor generator **2.** The battery 50 has a positive electrode terminal 51 and a negative electrode terminal 52. The positive electrode terminal 51 of this embodiment is an example of the "positive electrode" of the present invention. The negative electrode terminal 52 of this embodiment is an example of the "negative electrode" of the present invention. As the battery 50, a high-voltage type lithium-ion battery (LiB) of 48 V can be cited, for example. However, the battery 50 is not limited to the lithium-ion battery. Moreover, the voltage of the battery 50 is not limited to 48 V but may be higher than or equal to 48 V.

The motor generator 2 is connected to a positive electrode wiring 174 which is connected to the positive electrode terminal 51 of the battery 50. The positive electrode wiring 174 is a wiring which electrically connects the positive electrode terminal 51 of the battery 50 and the motor generator 2. The positive electrode wiring 174 is an example of the "first wiring" of the present invention. In addition, the motor generator 2 is connected to a negative electrode wiring 175 which is connected to the negative electrode terminal 52 of the battery 50. The negative electrode wiring 175 is a wiring which electrically connects the negative electrode terminal 52 of the battery 50 and the motor generator **2.** The negative electrode wiring 175 is an example of the "second wiring" of the present invention.

The battery pack 40 further includes a positive electrode side contactor 75, a negative electrode side contactor 76, and a current value detection unit 65. Note that the battery pack 40 may not necessarily have both the positive electrode side contactor 75 and the negative electrode side contactor 76, and may have only the positive electrode side contactor 75 or only the negative electrode side contactor 76. The following description will take the case where the battery pack 40 includes both the positive electrode side contactor 75 and the negative electrode side contactor 76 as an example.

The positive electrode side contactor 75 is an example of the "first contactor" of the present invention, and is provided on the electric circuit between the positive electrode terminal 51 of the battery 50 and the motor generator 2, that is, on the positive electrode wiring 174. The positive electrode side contactor 75 is electrically connected to the ECU 150 by a signal line 181 and performs the opening/closing of the positive electrode wiring 174 on the basis of a control signal transmitted from the ECU 150 via the signal line 181.

Note that the positive electrode side contactor 75 may be electrically connected to the BMU 85. In such case, the positive electrode side contactor 75 performs the opening/closing of the positive electrode wiring 174 on the basis of a control signal transmitted from the BMU 85.

The negative electrode side contactor 76 is an example of the "second contactor" of the present invention, and is provided on the electric circuit between the negative electrode terminal 52 of the battery 50 and the motor generator 2, that is, on the negative electrode wiring 175. The negative electrode side contactor 76 is electrically connected to the BMU 85 by a signal line 182 and performs the opening/closing of the negative electrode wiring 175 on the basis of a control signal transmitted from the BMU 85 via the signal line 182.

Note that the negative electrode side contactor 76 may be electrically connected to the ECU 150. In such case, the negative electrode side contactor 76 performs the opening/closing of the negative electrode wiring 175 on the basis of a control signal transmitted from the ECU 150.

The BMU 85 is electrically connected to the battery 50 by a signal line 183 and detects the value of a voltage of the battery 50 on the basis of a signal transmitted from the battery 50 via the signal line 183. Specifically, the BMU 85 detects the value of a voltage of each cell built in to the battery 50 by using the internal circuit built in to the BMU 85 itself, and detects the total sum of the value of the voltage of the respective cells as the value of the voltage of the battery 50. The BMU 85 is monitoring the state of the battery 50 and can detect an abnormality of the battery 50 on the basis of a signal transmitted from the battery 50 via the signal line 183. For example, the BMU 85 detects the value of a voltage of the battery 50 on the basis of a signal transmitted from the battery 50 via the signal line 183 and detects an overcharge abnormality and an over-discharge abnormality.

The BMU 85 is electrically connected to the current value detection unit 65 by a signal line 184 and obtains a current value from the current value detection unit 65 via the signal line 184. The current value detection unit 65 is provided on the positive electrode wiring 174 and detects the value of a current flowing through the positive electrode wiring 174. That is, the BMU 85 obtains the value of a current flowing through the positive electrode wiring 174 from the current value detection unit 65 via the signal line 184. The BMU 85 detects an overcurrent abnormality on the basis of the value of the current obtained from the current value detection unit 65 via the signal line 184. Alternatively, the BMU 85 detects an over-temperature abnormality on the basis of a cell temperature obtained from a CMU (Cell Management Unit; not shown).

Moreover, the BMU 85 is electrically connected to the ECU 150 by a signal line 193 and controls the negative electrode side contactor 76 on the basis of a control signal transmitted from the ECU 150 via the signal line 193. The ECU 150 and the BMU 85 communicate with each other over the CAN, for example, and mutually monitor the state of the other.

Here, in a secondary battery such as a lithium-ion battery, the internal resistance increases due to storage for a long time or usage for a long time, leading to an increased amount of voltage drop during discharging, resulting in the degradation of the internal resistance occurring. With respect to this, the following description will be explained with reference to the drawings.

Fig. 2 is a graph showing a behavior example of the voltage fluctuation of the battery when a current flows from the battery toward the motor generator.

Fig. 3 is a graph showing the relationship between the degree of degradation and the amount of voltage change during charging and discharging and between the degree of degradation and the output.

As shown in Fig. 2, if the current flows from the battery 50 toward the motor generator 2 only for a predetermined time, the value of a voltage of the battery 50 detected by the BMU 85 drops. That is, during the discharging of the battery 50, a voltage drop occurs in the battery 50. Then, for example, if the internal resistance of the battery 50 increases due to the metal compound adhering to the negative electrode of the battery 50, and the degradation the internal resistance of the battery 50 occurs, the amount of voltage drop during discharging increases, as indicated by the arrow shown in Fig. **2****.**

Furthermore, as shown in Fig. 3, if the degradation of the internal resistance of the battery 50 occurs, and the amount of voltage change during charging and discharging (that is, the amount of voltage drop during discharging in the description of Fig. 2) is greater than or equal to a threshold value, the ECU 150 may impose output limitations to suppress the voltage range.

Here, as a general degradation detection method for secondary batteries such as lithium-ion batteries, for example, a method using a discharge resistor such as a DC/DC converter or a load is cited. However, in such degradation detection method, a discharge resistor is required, so it is difficult to conveniently diagnose the degree of degradation of the internal resistance of the battery by means of the battery pack alone. The battery 50 of the battery pack 40 mounted on the hybrid system 10 is provided as an assembled battery in which a plurality of cells are connected in series to obtain the required voltage (48 V in the above example). Therefore, as described above, the battery pack 40 includes not only the battery 50, but also various electrical devices such as the positive electrode side contactor 75, the negative electrode side contactor 76, and the current value detection unit 65. Hence, depending on the degradation detection method, at least one of the resistance components of the positive electrode side contactor 75, the negative electrode side contactor 76 and the current value detection unit 65 may be included, so that it is difficult to conveniently diagnose the degree of degradation of the internal resistance of the battery by means of the battery pack alone.

With respect to this, as shown in Fig. 1, the battery pack 40 according to this embodiment further includes an AC constant current source 3 and an AC voltmeter **4.** The AC constant current source 3 is connected to the positive electrode wiring 174 at a connection point 33 between the positive electrode terminal 51 of the battery 50 and the positive electrode side contactor 75 via a first lead 31. The connection point 33 of this embodiment is an example of the "second connection point" of the present invention. In the battery pack 40 shown in Fig. 1, the AC constant current source 3 is connected to the positive electrode wiring 174 at the connection point 33 between the positive electrode terminal 51 of the battery 50 and the current value detection unit 65 via the first lead 31.

In addition, the AC constant current source 3 is connected to the negative electrode wiring 175 at a connection point 34 between the negative electrode terminal 52 of the battery 50 and the negative electrode side contactor 76 via a second lead 32. The connection point 34 of this embodiment is an example of the "fourth connection point" of the present invention.

The AC constant current source 3 is electrically connected to the BMU 85 by a signal line 186, and supplies an AC constant current with a frequency of, for example, 1 kilohertz (kHz) to the battery 50 via the first lead 31 and the second lead 32 on the basis of a signal transmitted from the BMU 85 via the signal line 186. Note that the frequency at which the AC constant current source 3 supplies the AC constant current to the battery 50 is not limited to 1 kHz.

The AC voltmeter 4 is connected to the positive electrode wiring 174 at the connection point 43 between the positive electrode terminal 51 of the battery 50 and the positive electrode side contactor 75 via the first lead 41. The connection point 43 of this embodiment is an example of the "first connection point" of the present invention. In the battery pack 40 shown in Fig. 1, the AC voltmeter 4 is connected to the positive electrode wiring 174 at the connection point 43 between the positive electrode terminal 51 of the battery 50 and the current value detection unit 65 via the first lead 41.

In addition, the AC voltmeter 4 is connected to the negative electrode wiring 175 at the connection point 44 between the negative electrode terminal 52 of the battery 50 and the negative electrode side contactor 76 via the second lead 42. The connection point 44 of this embodiment is an example of the "third connection point" of the present invention.

The AC voltmeter 4 detects the value of a voltage generated between the positive electrode terminal 51 of the battery 50 and the negative electrode terminal 52 of the battery 50 when the AC constant current source 3 supplies an AC constant current to the battery 50 on the basis of a signal transmitted from the BMU 85.

The BMU 85 is electrically connected to the AC voltmeter 4 by a signal line 185, and obtains, via the signal line 185, the value of the voltage detected by the AC voltmeter **4.** That is, the BMU 85 obtains, from the AC voltmeter 4 via the signal line 185, the value of a voltage generated between the positive electrode terminal 51 of the battery 50 and the negative electrode terminal 52 of the battery 50 when the AC constant current source 3 supplies an AC constant current to the battery 50 on the basis of a signal transmitted from the BMU 85. Then, the BMU 85 calculates the internal resistance of the battery 50 on the basis of the value of the voltage obtained from the AC voltmeter **4.**

As shown in Fig. 1, the connection point 43, at which the AC voltmeter 4 is connected to the positive electrode wiring 174, is located between the connection point 33, at which the AC constant current source 3 is connected to the positive electrode wiring 174, and the positive electrode terminal 51. The connection point 44, at which the AC voltmeter 4 is connected to the negative electrode wiring 175, is located between the connection point 34, at which the AC constant current source 3 is connected to the negative electrode wiring 175, and the negative electrode terminal 52. In addition, since the impedance (i.e., internal resistance) of the AC voltmeter 4 is very high, when the AC constant current source 3 supplies an AC constant current to the battery 50 on the basis of a signal transmitted from the BMU 85, the current hardly flows through the first lead 41 and the second lead 42 connected to the AC voltmeter 4. As a result, the AC voltmeter 4 can detect the value of a voltage generated between the positive electrode terminal 51 of the battery 50 and the negative electrode terminal 52 of the battery 50 without being influenced by the respective wiring resistances of the first lead 41 and the second lead 42, as well as the respective contact resistances at the connection point 43 and the connection point 44.

Next, a second embodiment of the present invention will be described.

Note that when configuration elements of the battery pack according to the second embodiment are similar to the configuration elements of the battery pack according to the first embodiment described above in relation with Figs. 1 to 3, duplicated description will be omitted as appropriate, and differences will be described below.

Fig. 4 is a block diagram showing a hybrid system on which a battery pack according to the second embodiment of the present invention is mounted.

The hybrid system 10A shown in Fig. 4 includes an engine 1, a motor generator 2, and a battery pack 40A.

The battery pack 40A includes a battery 50, and a BMU 85A. The BMU 85A of this embodiment is an example of the "control unit" of the present invention. BMU 85A includes an AC constant current source 3 and an AC voltmeter **4.** That is, in the battery pack 40A of this embodiment, the AC constant current source 3 and the AC voltmeter 4 described above in relation with Figs. 1 to 3 are included in the BMU 85A. In this respect, the battery pack 40A according to the second embodiment is different from the battery pack 40 according to the first embodiment described above in relation with Figs. 1 to **3****.**

The AC constant current source 3 and the AC voltmeter 4 may be implemented by means of hardware or may be implemented by means of a combination of hardware and software. Alternatively, the AC constant current source 3 and the AC voltmeter 4 may be implemented by a computer executing a program stored in a storage unit (not shown) of the BMU 85A. The "computer" as used herein is not limited to a personal computer, but also includes an arithmetic processing apparatus and a microcomputer which are included in an information processing apparatus, and collectively refers to a device and an apparatus which are capable of implementing the functions of the present invention with a program.

The AC constant current source 3 supplies an AC constant current with a frequency of, for example, 1 kilohertz (kHz) to the battery 50 via the signal line 183 on the basis of a signal transmitted from the BMU 85A. Note that the frequency at which the AC constant current source 3 supplies the AC constant current to the battery 50 is not limited to 1 kHz.

The AC voltmeter 4 detects the value of a voltage generated between the positive electrode terminal 51 of the battery 50 and the negative electrode terminal 52 of the battery 50 when the AC constant current source 3 supplies an AC constant current to the battery 50 on the basis of a signal transmitted from the BMU 85. As described above in relation with Fig. 1, for example, the AC voltmeter 4 detects the value of a voltage of each cell built in to the battery 50 on the basis of a signal transmitted from the battery 50 via the signal line 183, and detects the total sum of the value of the voltage of the respective cells as the value of a voltage of the battery 50.

The BMU 85A obtains the value of the voltage detected by the AC voltmeter **4.** Then, the BMU 85A calculates the internal resistance of the battery 50 on the basis of the value of the voltage obtained from the AC voltmeter 4. The rest of the configuration is similar to the configuration elements of the battery pack 40 according to the first embodiment described above in relation with Figs. 1 to **3****.**

Fig. 5 is a flowchart showing the diagnosis processing of the degree of degradation of the battery according to this embodiment.

Note that the flowchart shown in Fig. 5 shows the diagnosis processing of the degree of degradation of the battery 50 in the battery pack 40 according to the first embodiment and in the battery pack 40A according to the second embodiment. That is, either of the battery pack 40 according to the first embodiment and the battery pack 40A according to the second embodiment is capable of performing the diagnosis processing related to the flowchart shown in Fig. 5. The following description will take the case where the battery pack 40 according to the first embodiment performs the diagnosis processing of the degree of degradation of the battery 50 as an example.

First, in step S1, the BMU 85 calculates the internal resistance of the battery 50 on the basis of the value of a voltage obtained from the AC voltmeter 4 before the battery pack 40 is mounted on the hybrid system 10. Specifically, before the battery pack 40 is mounted on the hybrid system 10, the BMU 85 supplies an AC constant current to the battery 50 by controlling the AC constant current source **3.** At this time, the AC voltmeter 4 detects the value of a voltage generated between the positive electrode terminal 51 of the battery 50 and the negative electrode terminal 52 of the battery 50. Then, the BMU 85 calculates the internal resistance of the battery 50 on the basis of the value of the voltage obtained from the AC voltmeter 4.

Subsequently, in step S2, the BMU 85 takes the internal resistance calculated before the battery pack 40 is mounted on the hybrid system 10 as a reference. Subsequently, in step S3, after the battery pack 40 is mounted on the hybrid system 10, the BMU 85 determines whether or not the number of charge and discharge cycles of the battery 50 reaches a predetermined number. The "predetermined number" as used herein is, for example, greater than or equal to 60,000. Alternatively, the "predetermined number" as used herein is, for example, greater than or equal to 60,000 and less than or equal to 80,000. However, the "predetermined number" related to the number of charge and discharge cycles of the battery 50 is not limited to this.

If the number of charge and discharge cycles of the battery 50 does not reach the predetermined number (step S3: NO), the BMU 85 will continue to determine whether or not the number of charge and discharge cycles of the battery 50 reaches the predetermined number in Step S3. In contrast, if the number of charge and discharge cycles of the battery 50 reaches the predetermined number (step S3: YES), in step S4, the BMU 85 supplies an AC constant current to the battery 50 by controlling the AC constant current source **3.**

Subsequently, in step S5, the AC voltmeter 4 detects the value of a voltage generated between the positive electrode terminal 51 of the battery 50 and the negative electrode terminal 52 of the battery 50.

Subsequently, in step S6, the BMU 85 calculates the internal resistance of the battery 50 on the basis of the value of the voltage obtained from the AC voltmeter **4.** Then, the BMU 85 diagnoses the degree of degradation of the battery 50 on the basis of the rate of increase in the internal resistance **(i.e.,** the internal resistance calculated when the number of charge and discharge cycles of the battery 50 reaches the predetermined number) calculated after the battery pack 40 is mounted on the hybrid system 10, compared to the internal resistance that is the reference **(i.e.,** the internal resistance calculated before the battery pack 40 is mounted on the hybrid system 10) set in step S2. For example, the BMU 85 determines that the degradation of the internal resistance of the battery 50 occurs when the rate of increase in the internal resistance calculated after the battery pack 40 is mounted on the hybrid system 10 compared to the internal resistance that is the reference is greater than or equal to a predetermined threshold value.

As described above, according to this embodiment, the battery pack 40 includes the AC constant current source 3 for supplying an AC constant current with a predetermined frequency to the battery 50; and the AC voltmeter 4 for detecting the value of a voltage between the positive electrode terminal 51 and the negative electrode terminal 52 when the AC constant current is supplied to the battery 50. Then, the BMU 85 supplies an AC constant current to the battery 50 by controlling the AC constant current source 3, calculates the internal resistance of the battery 50 on the basis of the value of a voltage detected by the AC voltmeter 4, and diagnoses the degree of degradation of the battery 50 on the basis of the calculated internal resistance. Specifically, the BMU 85 takes the internal resistance calculated before the battery pack 40 is mounted on the hybrid system 10 as a reference, and diagnoses the degree of degradation of the battery 50 on the basis of the rate of increase in the internal resistance calculated after the battery pack 40 is mounted on the hybrid system 10, compared to the internal resistance that is the reference. As a result, the battery pack 40 according to this embodiment can conveniently diagnose the degree of degradation of the internal resistance of the battery 50 by means of the battery pack 40 alone, without requiring a discharge resistor such as a DC/DC converter or a load. Such an effect is similarly obtained in the battery pack 40A according to the second embodiment.

Furthermore, in the battery pack 40 according to the first embodiment, the AC voltmeter 4 is connected to the positive electrode wiring 174 at the connection point 43 between the positive electrode terminal 51 of the battery 50 and the positive electrode side contactor 75 (the current value detection unit 65 in the battery pack 40 shown in Fig. 1) via the first lead 41. In addition, the AC voltmeter 4 is connected to the negative electrode wiring 175 at the connection point 44 between the negative electrode terminal 52 of the battery 50 and the negative electrode side contactor 76 via the second lead 42. As a result, the battery pack 40 suppresses the resistance components of the positive electrode side contactor 75, the negative electrode side contactor 76 and the current value detection unit 65 so that said resistance components are not included, thereby suppressing the influence caused by the resistance components of the positive electrode side contactor 75, the negative electrode side contactor 76 and the current value detection unit 65, and can conveniently diagnose the degree of degradation of the internal resistance of the battery 50 by means of the battery pack 40 alone.

Next, a third embodiment of the present invention will be described.

Note that when configuration elements of the battery pack according to the third embodiment are similar to the configuration elements of the battery pack according to the first embodiment described above in relation with Figs. 1 to 3, duplicated description will be omitted as appropriate, and differences will be described below.

Fig. 6 is a block diagram showing a hybrid system on which a battery pack according to the third embodiment of the present invention is mounted.

The hybrid system 10B shown in Fig. 6 includes an engine 1, a motor generator 2, and a battery pack 40B.

Compared with the battery pack 40 described above in relation with Fig. 1, the battery pack 40B according to this embodiment does not include an AC constant current source 3 and an AC voltmeter 4, but further includes a third wiring 176, a fourth wiring 177, a first terminal 53 and a second terminal 54. In this respect, the battery pack 40B according to the third embodiment is different from the battery pack 40 according to the first embodiment described above in relation with Figs. 1 to 3.

The third wiring 176 is connected at one end to the positive electrode wiring 174. Specifically, the third wiring 176 is connected at one end to the positive electrode wiring 174 between the positive electrode terminal 51 of the battery 50 and the positive electrode side contactor 75. In the battery pack 40B shown in Fig. 6, the third wiring 176 is connected at one end to the positive electrode wiring 174 between the positive electrode terminal 51 of the battery 50 and the current value detection unit 65.

In addition, the third wiring 176 is connected to the first terminal 53 at the other end. The first terminal 53 is provided in a casing 401 of the battery pack 40B. For example, as shown in Fig. 6, the first terminal 53 is attached to an outer surface 411 of the casing 401 and protrudes outward from the outer surface 411 of the casing 401. The first terminal 53 is connected to one terminal of a measuring device (not shown) for measuring the internal resistance of the battery 50. As a measuring device for measuring the internal resistance of the battery 50, for example, a battery tester can be cited.

The fourth wiring 177 is connected at one end to the negative electrode wiring 175. Specifically, the fourth wiring 177 is connected at one end to the negative electrode wiring 175 between the negative electrode terminal 52 of the battery 50 and the negative electrode side contactor 76. In addition, the fourth wiring 177 is connected to the second terminal 54 at the other end. The second terminal 54 is provided in the casing 401 of the battery pack 40B. For example, as shown in Fig. 6, the second terminal 54 is attached to the outer surface 411 of the casing 401 and protrudes outward from the outer surface 411 of the casing 401. The second terminal 54 is connected to the other terminal of the measuring device for measuring the internal resistance of the battery 50. As described above, as a measuring device for measuring the internal resistance of the battery 50, for example, a battery tester can be cited.

For example, a battery tester (not shown) is connected at one terminal to the first terminal 53 and at the other terminal to the second terminal 54, supplies an AC constant current with a frequency of 1 kHz to the battery 50 via the third wiring 176 and the fourth wiring 177, and calculates the internal resistance of the battery 50 from the value of a voltage of an AC voltmeter that the battery tester includes.

As shown in Fig. 6, the battery pack 40B further includes a fuse 95. The fuse 95 is provided on the third wiring 176 and cuts off the third wiring 176 when an overcurrent flows through the third wiring 176. As a result, even if the third wiring 176 and the fourth wiring 177 are in contact with each other and an overcurrent flows through the electric circuit composed of the battery 50, the third wiring 176, and the fourth wiring 177, the fuse 95 can protect the electric circuit of the battery pack 40B by cutting off the third wiring 176.

The fuse 95 may be provided on the fourth wiring 177 instead of the third wiring 176. Alternatively, fuse 95 may be provided on both the third wiring 176 and the fourth wiring 177. Even in such case, the fuse 95 can protect the electric circuit of the battery pack 40B by cutting off at least one of the third wiring 176 and the fourth wiring 177. The rest of the configuration is similar to the configuration elements of the battery pack 40 according to the first embodiment described above in relation with Figs. 1 to 3.

As described above, according to the battery pack 40B according to this embodiment, the first terminal 53 is connected to one terminal of the measuring device for measuring the internal resistance of the battery 50. Moreover, the second terminal 54 is connected to the other terminal of the measuring device for measuring the internal resistance of the battery 50. In addition, a measuring device such as a battery tester is connected to the first terminal 53 and the second terminal 54, and the internal resistance of the battery 50 can be calculated from the value of a voltage of an AC voltmeter by supplying an AC constant current with a frequency of, for example, 1 kHz to the battery 50 via the third wiring 176 and the fourth wiring 177. As a result, the battery pack 40B according to this embodiment can conveniently diagnose the degree of degradation of the internal resistance of the battery 50 by means of the battery pack 40B alone, without requiring a discharge resistor such as a DC/DC converter or a load.

In addition, the third wiring 176 is connected at one end to the positive electrode wiring 174 between the positive electrode terminal 51 of the battery 50 and the positive electrode side contactor 75 (the current value detection unit 65 in the battery pack 40B shown in Fig. 6). The fourth wiring 177 is connected at one end to the negative electrode wiring 175 between the negative electrode terminal 52 of the battery 50 and the negative electrode side contactor 76. Therefore, the resistance components of the positive electrode side contactor 75, the negative electrode side contactor 76 and the current value detection unit 65 are suppressed and not included, that is, the influence caused by the resistance components of the positive electrode side contactor 75, the negative electrode side contactor 76 and the current value detection unit 65 is suppressed, so that the degree of degradation of the internal resistance of the battery 50 can be conveniently diagnosed by means of the battery pack 40B alone.

The battery pack 40B according to this embodiment includes the first terminal 53 and the second terminal 54 which act as service ports that can constantly detect high voltage, allowing for the convenient diagnosis of the degree of degradation of the internal resistance of the battery 50 by means of the battery pack 40B alone not only during the production process of the battery pack 40B but also after the battery pack 40B has been mounted on the hybrid system 10B and made available on the market.

The embodiments of the present invention have been explained above. However, it is to be understood that the present invention is not limited to the embodiments described above and that various modifications can be made without departing from the scope of the appended claims. The configurations of the embodiments described above can be partially omitted or arbitrarily combined in manners that differ from those described above.

### Reference Signs List

- 1: Engine
- 2: Motor generator
- 3: AC constant current source
- 4: AC voltmeter
- 10: Hybrid system
- 10A: Hybrid system
- 10B: Hybrid system
- 31: First lead
- 32: Second lead
- 33: Connection point
- 34: Connection point
- 40: Battery pack
- 40A: Battery pack
- 40B: Battery pack
- 41: First lead
- 42: Second lead
- 43: Connection point
- 44: Connection point
- 50: Battery
- 51: Positive electrode terminal
- 52: Negative electrode terminal
- 53: First terminal
- 54: Second terminal
- 65: Current value detection unit
- 75: Positive electrode side contactor
- 76: Negative electrode side contactor
- 85: BMU
- 85A: BMU
- 95: Fuse
- 150: ECU
- 174: Positive electrode wiring
- 175: Negative electrode wiring
- 176: Third wiring
- 177: Fourth wiring
- 181: Signal line
- 182: Signal line
- 183: Signal line
- 184: Signal line
- 185: Signal line
- 186: Signal line
- 193: Signal line
- 401: Casing
- 411: Outer surface

## Claims

1. A battery pack mounted on a hybrid system, the battery pack comprising:
a battery for supplying electric power to a motor generator of the hybrid system;
a contactor provided on at least one of a first wiring between a positive electrode of the battery and the motor generator and a second wiring between a negative electrode of the battery and the motor generator, and performing opening/closing of at least one of the first wiring and the second wiring;
an AC constant current source supplying to the battery an AC constant current with a predetermined frequency;
an AC voltmeter detecting a value of a voltage between the positive electrode and the negative electrode when the AC constant current is supplied to the battery; and
a control unit supplying the AC constant current to the battery by controlling the AC constant current source, calculating internal resistance of the battery on the basis of the value of the voltage detected by the AC voltmeter, and diagnosing a degree of degradation of the battery on the basis of the internal resistance.

2. The battery pack according to claim 1, wherein the AC constant current source and the AC voltmeter are respectively connected to the first wiring and the second wiring.

3. The battery pack according to claim **2,** wherein
the contactor comprises:
a first contactor provided on the first wiring and performing the opening/closing of the first wiring; and
a second contactor provided on the second wiring and performing the opening/closing of the second wiring; and
the AC constant current source and the AC voltmeter are respectively connected to the first wiring between the positive electrode and the first contactor and the second wiring between the negative electrode and the second contactor.

4. The battery pack according to claim **3,** wherein
a first connection point, at which the AC voltmeter is connected to the first wiring, is located between a second connection point, at which the AC constant current source is connected to the first wiring, and the positive electrode, and
a third connection point, at which the AC voltmeter is connected to the second wiring, is located between a fourth connection point, at which the AC constant current source is connected to the second wiring, and the negative electrode.

5. The battery pack according to claim 1, wherein the AC constant current source and the AC voltmeter are included in the control unit.

6. The battery pack according to claim 1, wherein the control unit takes the internal resistance, which is calculated before the battery pack is mounted on the hybrid system, as a reference, and diagnoses the degree of degradation on the basis of a rate of increase in the internal resistance, which is calculated after the battery pack is mounted on the hybrid system, relative to the internal resistance taken as the reference.

7. The battery pack according to claim 6, wherein after being mounted on the hybrid system, when the number of charge and discharge cycles of the battery reaches a predetermined number, the control unit supplies the AC constant current to the battery by controlling the AC constant current source, and calculates the internal resistance.

8. The battery pack according to claim 7, wherein the predetermined number is greater than or equal to 60,000.

9. The battery pack according to any one of claims 1 to 8, wherein the predetermined frequency is 1 kHz.

10. A battery pack mounted on a hybrid system, the battery pack comprising:
a casing;
a battery provided inside the casing and supplying electric power to a motor generator of the hybrid system;
a contactor provided on at least one of a first wiring between a positive electrode of the battery and the motor generator and a second wiring between a negative electrode of the battery and the motor generator, and performing opening/closing of at least one of the first wiring and the second wiring;
a third wiring connected to the first wiring;
a fourth wiring connected to the second wiring;
a first terminal connected to an end of the third wiring and provided in the casing, and connected to one terminal of a measuring device measuring the internal resistance of the battery; and
a second terminal connected to an end of the fourth wiring and provided in the casing, and connected to another terminal of the measuring device.

11. The battery pack according to claim 10, wherein
the contactor comprises:
a first contactor provided on the first wiring and performing the opening/closing of the first wiring; and
a second contactor provided on the second wiring and performing the opening/closing of the second wiring, and
the third wiring is connected to the first wiring between the positive electrode and the first contactor, and
the fourth wiring is connected to the second wiring between the negative electrode and the second contactor.

12. The battery pack according to claim 10, wherein the first terminal and the second terminal are each attached to an outer surface of the casing.

13. The battery pack according to claim 12, wherein the first terminal and the second terminal each protrude outward from the outer surface.

14. The battery pack according to any one of claims 10 to 13, further comprising: a fuse provided on the third wiring and cutting off the third wiring when an overcurrent flows through the third wiring.

15. The battery pack according to any one of claims 10 to 13, further comprising: a fuse provided on the fourth wiring and cutting off the fourth wiring when an overcurrent flows through the fourth wiring.
